**Europäisches Patentamt**

**European Patent Office**

**Office européen des brevets**

(19)

(11) Veröffentlichungsnummer: **0 132 745**
**B1**

(12) **EUROPÄISCHE PATENTSCHRIFT**

(45) Veröffentlichungstag der Patentschrift:
**18.10.89**

(51) Int. Cl.⁴: **G 01 R 19/20, G 01 R 15/02**

(21) Anmeldenummer: **84108347.0**

(22) Anmeldetag: **16.07.84**

(54) **Einrichtung zur Messung von Gleichströmen.**

(30) Priorität: **20.07.83 DD 253232**
**24.02.84 DD 260321**

(43) Veröffentlichungstag der Anmeldung:
**13.02.85 Patentblatt 85/7**

(45) Bekanntmachung des Hinweises auf die Patenterteilung:
**18.10.89 Patentblatt 89/42**

(84) Benannte Vertragsstaaten:
**AT CH DE FR GB LI**

(56) Entgegenhaltungen:
**DE-A- 2 224 101**
**DE-B- 2 112 315**
**DE-B- 2 834 499**
**US-A- 4 298 838**

**ETZ, Band 100, Nr. 24, 1979, Seiten 1390-1394: J. LISSER et al.: "Nullfluss-Stromwandler zur Messung von Gleich- und Wechselströmen"**
**G.P. SCHERNUS: "Potentialfreie digitale Messung von Gleichströmen", 1974, Dissertation, Braunschweig**
**G. TRENKLER: "Die Messung schwacher magnetischer Felder mittels Magnetometer mit direkter Zeitverschlüsselung", 1968, Dissertation, Braunschweig**

(73) Patentinhaber: **VEB Transformatoren- und Röntgenwerk "Hermann Matern", Overbeckstrasse 48, DDR-8030 Dresden (DD)**

(72) Erfinder: **Ermisch, Jochen, Dr., Sidonienstrasse 5, DDR-8122 Radebeul (DD)**
Erfinder: **Hertwig, Norbert, Dipl.-Ing., Platz d. Friedens 66, DDR-9202 Frauenstein (DD)**
Erfinder: **Reiss, Matthias, Dipl.-Ing., Siedlerstrasse 9, DDR-8270 Coswig (DD)**

(74) Vertreter: **Patentanwälte Beetz sen. - Beetz jun. Timpe - Siegfried - Schmitt-Fumian, Steinsdorfstrasse 10, D-8000 München 22 (DE)**

## Beschreibung

Die Erfindung bezieht sich auf eine Einrichtung zur Messung von Gleichströmen, die aus einem Magnetkreis mit Isthmus, einer Meßwicklung, einer Kompensationswicklung, einer Indikatorwicklung sowie einer Vormagnetisierungswicklung besteht. Die Meßwicklung führt den zu messenden Gleichstrom, der auch von einer Wechselstromkomponente überlagert sein kann. Sie besteht aus wenigen Windungen bzw. aus einem einzigen Leiter. Die Kompensationswicklung wird von dem Strom durchflossen, der den zu messenden Strom abbildet, welcher von einem Differenzverstärker getrieben wird. Die Indikatorwicklung liefert die Eingangsgrößen für den Differenzverstärker und bewirkt zusammen mit ihm, daß in der Kompensationswicklung stets ein Strom fließt, der im Kern zu einem resultierenden Fluß nahe Null führt.

Die Einrichtung arbeitet also nach dem Prinzip des Nullflußwandlers.

Die ebenfalls noch vorgesehene Vormagnetisierungswicklung wird mit einem Wechselstrom beaufschlagt; bevorzugt wird ein Wechselstrom mit dreieckförmigem Verlauf angewandt (Lisser; Ribberink «Nullfluß-Stromwandler zur Messung von Gleichströmen und Wechselströmen» etz Bd. 100 (1979) H 24).

Es ist bekannt, einen Gleichstromwandler aus einem Magnetkern, einer Meßwicklung, die quasi die Primärwicklung darstellt, einer Induktionswicklung, die der Sekundärwicklung entspricht, sowie einer Vormagnetisierungswicklung aufzubauen, wobei die Vormagnetisierungswicklung einen Wechselstrom führt. Aus dem Stromverlauf in der Induktionswicklung, z.B. seinem Oberwellengehalt, wird auf den Strom im Gleichstromkreis geschlossen (Schermus, Dissertation TU Braunschweig 1974).

Bei Magnetkernen, wo eine vorzeitige magnetische Sättigung bzw. eine Beeinflussung der Magnetisierungskennlinie erwünscht ist, ist es bekannt, bestimmte Strecken im Querschnitt zu verengen. Diese Querschnittsverengung erfolgt z.B. derart, daß einseitig oder beidseitig Aussparungen mit H-förmiger und/oder U-förmiger oder V-förmiger Kontur vorgesehen werden. Auch ist es möglich, eine oder mehrere Bohrungen bzw. Langlöcher im Kernquerschnitt vorzusehen. In diesem als Isthmus bezeichneten Bereich wurden auch schon Wicklungen vorgesehen, die aber den Fluß des gesamten Magnetkreises umfaßten (DE-A-2 112 315). Des weiteren ist es bekannt, einen Magnetkern an verschiedenen Stellen mit Isthmen zu versehen.

Ferner ist bekannt, den Ausgang der Indikatorwicklung auf einen Verstärker arbeiten zu lassen und den Verstärkerausgangsstrom, der den zu messenden Strom abbildet, durch eine Kompensationswicklung zu treiben, wobei am Verstärker ein Signal anliegt, wenn die Summe des durch die Kompensationswicklung erzeugten Flusses und des durch die Meßwicklung erzeugten Flusses bei vorzeichenrichtiger Addition nicht Null ergibt. Für die Gewinnung des Verstärkereingangssignales finden dabei Hallgeneratoren, Feldplatten oder Indikatorwicklungen Anwendung (Schermus a.a.O. oder Lisser und Ribberink a.a.O.).

Auf eine solche Anordnung mit Indikatorwicklung bezieht sich die nachfolgend beschriebene Erfindung.

Diese vorausgesetzte Anordnung hat vor allem den Nachteil, daß für die Vormagnetisierung des gesamten Magnetkernes eine beträchtliche Leistung aufgebracht werden muß, und daß nicht nur die Kompensationswicklung, sondern auch die Vormagnetisierungswicklung eine hohe Windungszahl aufweisen muß.

Des weiteren ist es bekannt, zur potentialfreien Messung von Strömen einen Magnetkern mit Meßwicklung, einer Vormagnetisierungswicklung und einer Indikatorwicklung auszustatten und an die Indikatorwicklung ein Differenzierglied und einen nachgeschalteten Schwellwertschalter zur Erzeugung einer Ausgangsimpulsspannung, deren Impulsdauer ein Maß für die Größe des Meßstromes ist, zu schalten (DE-B-2 834 499). Die Anordnung eines Differenziergliedes und eines Schwellwertschalters verfolgt hier den Zweck, einen dem den Gleichstrom abbildenden Impuls überlagerten Impuls (der im Zeitbereich des Wendepunktes des Vormagnetisierungsstromes auftritt) zu eliminieren.

Neben der Bewertung der Impulsdauer wurde bei Einrichtungen zur Messung der magnetischen Feldstärke auch schon die sich ergebende zeitliche Verschiebung der Ausgangsimpulse auf dem Oszillographenschirm als Maß für die Feldstärke ausgenutzt (Trenkler «Die Messung schwacher magnetischer Felder mittels Magnetometer mit direkter Zeitverschlüsselung», Dissertation TU Braunschweig 1968).

Auf die Anwendung dieses Prinzips bei Gleichstromwandlern bezieht sich eine Ausführungsform der nachstehend beschriebenen Erfindung.

Der Erfindung liegt die Aufgabe zugrunde, einen Gleichstromwandler nach dem Nullflußprinzip anzugeben, der für seine Vormagnetisierung mittels einer Wechselspannung einer verminderten Leistung bedarf; fernerhin soll der Gleichstromwandler sowohl eine genaue Messung von Gleichströmen als auch eine hinreichend genaue Übertragung von höherfrequenten Vorgängen, die dem zu messenden Gleichstrom überlagert sind, gewährleisten.

Diese Aufgabe wird durch einen Wandler gemäß dem Hauptanspruch gelöst.

Vorteilhafte Weiterbildungen der Erfindungskonzeption sind Gegenstand der abhängigen Ansprüche.

Neben dem außerordentlichen Vorteil eines geringen Magnetisierungsleistungsbedarfs weist die erfindungsgemäße Einrichtung noch den wesentlichen Vorteil auf, daß sich der durch den Strom in der Vormagnetisierungswicklung erzeugte hochfrequente Fluß überwiegend in der Parallelschaltung der magnetischen Leiter schließt und damit eine Induktion einer höherfrequenten Spannung in der Meßwicklung ausgeschlossen wird.

Durch die Anordnung von zwei oder auch mehr Isthmen mit Parallelschaltung magnetischer Leiter ist es möglich, den Einfluß von Fremdfeldern zu unterdrücken, wenn die Induktionswicklungen so geschaltet sind, daß sich der Einfluß der Fremdfelder kompensiert.

Die erfindungsgemäße Einrichtung nach Anspruch 9, bei der zwei beziehungsweise eine geradzahlige Anzahl von Indikatorwicklungen vorgesehen sind, gewährleistet unter Ausnutzung der Verschiebung der Ausgangsimpulse der Indikatorwicklungen insbesondere ein gutes dynamisches Übertragungsvermögen.

Das Erfindungskonzept wird im folgenden anhand eines Ausführungsbeispiels unter Bezug auf die Zeichnungen näher erläutert; es zeigen:

Fig. 1 einen Gleichstromwandler in Einleiterausführung gemäß der Erfindung,

Fig. 2 in den einzelnen Abbildungen 2a bis 2g verschiedene Konfigurationen von magnetischen Leitern und

Fig. 3 eine bevorzugte Schaltungsanordnung eines erfindungsgemäßen Gleichstromwandlers.

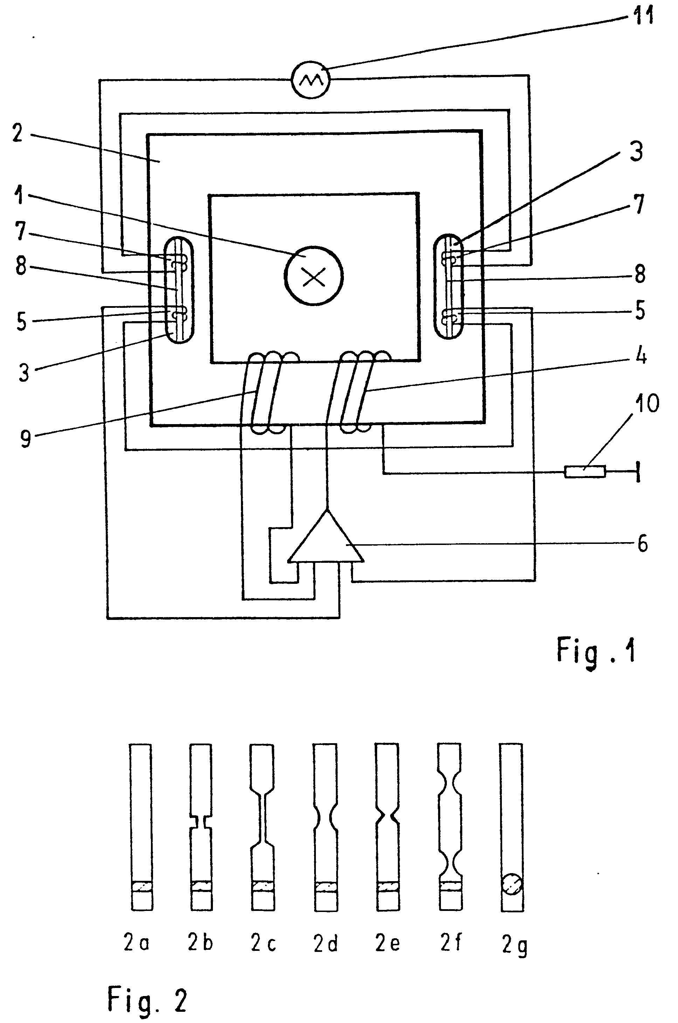

In der Fig. 1 ist ein Gleichstromwandler in Einleiterbauweise gezeigt, wo ein den zu messenden Gleichstrom führender Leiter 1 im Zentrum eines Magnetkreises 2 angeordnet ist. Dieser Magnetkreis 2 weist in zwei Schenkeln je einen Isthmus 3 auf. Die vorausgesetzte Gattung eines nach dem Nullflußprinzip arbeitenden Gleichstromwandlers bedingt weiterhin die Anordnung einer Kompensationswicklung 4, die in nicht gezeichneter Weise möglichst gleichmäßig über den Umfang des Magnetkreises 2 verteilt ist und die einen Strom führt, der den Strom in der Meßwicklung 1 repräsentiert, also quasi der Sekundärstrom ist. In Reihe mit dieser Kompensationswicklung 4 liegt eine Bürde 10. Kompensationswicklung 4 und Bürde 10 werden von einem Differenzverstärker 6 derart gespeist, daß in der Kompensationswicklung 4 stets ein Strom fließt, der einen Fluß erzeugt, welcher bei vorzeichenrichtiger Addition mit dem Fluß, der vom Strom in der Meßwicklung 1 hervorgerufen wird, den Betrag Null bzw. quasi Null ergibt.

Zu diesem Zweck wird der Differenzverstärker 6 von Spannungen gesteuert, die mittels Indikatorwicklungen 5 erzeugt werden. Diese sind in erfindungsgemäßer Weise zusammen mit je einer Vormagnetisierungswicklung 7 auf einem magnetischen Leiter 8 aufgebracht, welcher im Isthmus 3 angeordnet ist und dort zusammen mit Teilen des Magnetkreises 2 eine Parallelschaltung magnetischer Leiter bildet. Durch diese Anordnung der Vormagnetisierungswicklung 7 und der Indikatorwicklung 5 auf einem Leiter einer Parallelschaltung von Leitern wird erreicht, daß nicht der gesamte Magnetkreis 2, sondern nur der die Wicklungen 5 und 7 tragende magnetische Leiter 8 mit seinen Rückschlüssen der Ummagnetisierung bedarf. Infolge des wesentlich kleineren Volumens dieses Leiters gegenüber dem Volumen des gesamten Magnetkreises 2 sinkt der Leistungsbedarf der Vormagnetisierungswicklung 7 beachtlich. Dies führt dazu, daß ein die Vormagnetisierungswicklung 7 speisender Wechselstromgenerator 11 leistungsarm aufgebaut werden kann.

Der magnetische Leiter 8, der die Indikatorwicklung 5 und die Vormagnetisierungswicklung 7 trägt, kann in verschiedener Weise ausgeführt sein.

Fig. 2 zeigt verschiedene Formen dieses Leiters. In Abbildung 2a weist der magnetische Leiter 8 die geometrisch einfache Gestalt eines im Querschnitt konstanten rechteckförmigen Bleches auf.

Die Abbildungen 2b bis 2e zeigen eine Form nach Abbildung 2a mit dem Unterschied, daß der Leiter selbst einen Isthmus aufweist, wobei die Konturen des Isthmus verschieden gestaltet sind, indem beispielsweise am Leiter beidseitig eine Querschnittsverengung in Form von rechteck-, trapez-, kreisabschnitt- oder keilförmigen Aussparungen vorgesehen ist.

Abbildung 2f zeigt einen magnetischen Leiter 8 nach Abbildung 2a, aber mit mehreren Isthmen. In Abbildung 2g ist ein magnetischer Leiter mit rundem Querschnitt gezeigt. Dieser Querschnitt ist besonders beim Einsatz magnetischer Leiter aus magnetischen Drähten, z.B. aus amorphem Material, geeignet.

Die magnetischen Leiter 8 sind aus hochpermeablem Material hergestellt, wobei die Materialsorten den Vorzug genießen, die hohe Permeabilität in Nullpunktnähe aufweisen.

Neben einer hohen Permeabilität soll das Material für den magnetischen Leiter 8 eine möglichst geringe Koerzitivfeldstärke aufweisen. Des weiteren sollte das Material eine Charakteristik B = f (H) aufweisen, die durch einen steilen Anstieg der Magnetisierungskennlinie gekennzeichnet ist und auch als Rechteckcharakter bezeichnet wird.

Neben dem Vorteil eines geringen Magnetisierungsleistungsbedarfs weist die erfindungsgemäße Anordnung noch den wesentlichen Vorteil auf, daß der durch den Strom in der Vormagnetisierungswicklung 7 erzeugte hochfrequente Fluß sich überwiegend in der Parallelschaltung der magnetischen Leiter schließt und damit eine Induktion einer höherfrequenten Spannung in der Meßwicklung 1 ausgeschlossen wird.

Damit ist zur Verwirklichung einer Einrichtung zur Gleichstrommessung nur ein einziger Magnetkreis erforderlich, da die bisher zur Kompensation der induzierten höherfrequenten Spannungen erforderlichen Kompensationskerne zur Vermeidung von HF-Störungen entfallen können. Dadurch wird auch der Vormagnetisierungsbedarf dieser Kompensationskerne eingespart.

Infolge der gezeigten Anordnung von zwei Isthmen mit Parallelschaltung magnetischer Leiter ist es möglich, den Einfluß von Fremdfeldern zu unterdrücken, wenn die Indikatorwicklungen 5 so geschaltet sind, daß sich der Einfluß der Fremdfelder kompensiert.

Zu diesem Zweck ist es auch möglich, mehr als zwei Isthmen verteilt auf den Magnetkreis 2 vorzusehen.

Im Differenzverstärker 6 werden die von den Indikatorwicklungen 5 herrührenden Spannungen so verarbeitet, daß in der Kompensationswicklung 4 ein den zu messenden Strom repräsentierender Strom fließt. Zur meßtechnischen Erfassung von Wechselstromanteilen an dem in der Meßwicklung 1 fließenden Gleichstrom ist es vorteilhaft, auf dem Magnetkreis 2 zusätzlich eine Induktionswicklung 9 vorzusehen, die eine Spannung liefert, welche die Wechselanteile am Fluß des Magnetkreises 2 abbildet.

Diese Induktionswicklung 9 arbeitet ebenfalls auf den Differenzverstärker 6 und bewirkt, daß diese so modifizierte Differenzverstärkeranordnung in der Kompensationswicklung 4 auch einen Wechselstrom treibt.

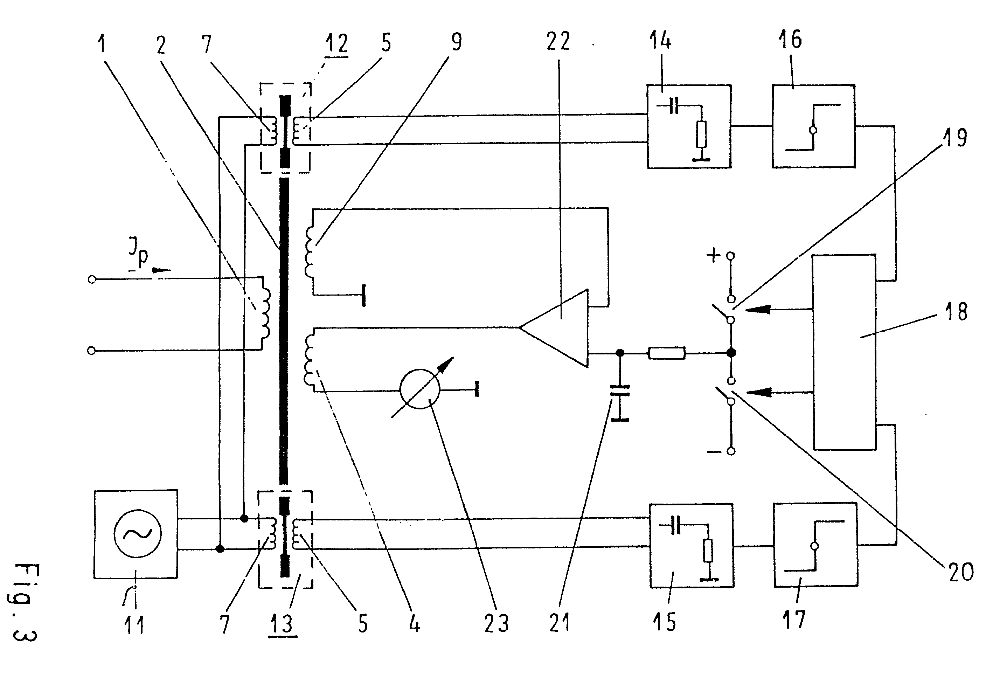

Fig. 3 zeigt eine bevorzugte Schaltungsanordnung des Gleichstromwandlers, die wiederum eine Meßwicklung 1, mit einen Isthmen enthaltenden Magnetkreis 2 und eine Kompensationswicklung 4 aufweist. Im Magnetkreis 2 sind zwei Isthmen vorgesehen, in denen jeweils Sonden 12 und 13 angeordnet sind. Diese tragen jeweils eine Vormagnetisierungswicklung 7 sowie eine Indikatorwicklung 5. Der Indikatorwicklung 5 der Sonde 12 ist ein Differenzierglied 14 nachgeschaltet. Ebenso arbeitet die Indikatorwicklung 5 der Sonde 13 auf ein Differenzierglied 15. Die Ausgänge der Differenzierglieder 14 und 15 liegen an Diskriminatoren 16 und 17. Die Ausgangsspannungen der Diskriminatoren 16 und 17 werden zur Steuerung einer Logikschaltung 18 genutzt, die ihrerseits Schalter 19 und 20 ansteuert. Die Schalter 19 und 20 liegen im Aufladekreis eines Kondensators 21, dessen Spannung eine Eingangsgröße eines Verstärkers 22 bildet. Dieser Verstärker 22 speist die Kompensationswicklung 4 sowie eine Bürde 23. Gleichfalls auf den Verstärker 22 arbeitet die auch hier zweckmäßigerweise auf den Magnetkreis 2 aufgebrachte Induktionswicklung 9.

Die vorstehend strukturell erläuterte Schaltung arbeitet wie folgt:

Der zu messende Gleichstrom $I_p$, der sowohl ein reiner Gleichstrom als auch ein sogenannter Mischstrom sein kann, durchfließt die Meßwicklung 1. Dies hat zur Folge, daß der Magnetkreis 2 mit seinen Sonden 12 und 13 magnetisiert wird. Diese Sonden 12 und 13 liefern ein impulsförmiges Ausgangssignal, dessen Frequenz identisch ist der Frequenz des Wechselstromgenerators 11, der die Vormagnetisierungswicklungen 7 speist. Der zeitliche Abstand dieser Impulse ist abhängig von der Richtung sowie auch von der Größe des Stroms $I_p$, der die Meßwicklung 1 durchfließt. Zur genaueren Identifizierung der Lage der Impulse der Indikatorwicklungen 5 zueinander werden die Ausgangsspannungen der Indikatorwicklungen 5 je einem Differenzierglied 14 bzw. 15 zugeführt. Das Ausgangssignal der Differenzierglieder 14 und 15 weist somit dann einen Nulldurchgang auf, wenn das Ausgangssignal der Indikatorwicklungen 5 jeweils einen Extremwert erreicht. Dieses Ausgangssignal wird mittels der Diskriminatoren 16 und 17 durch die Erfassung der Nulldurchgänge der Ausgangssignale der Differenzierglieder 14 und 15 in eine äquidistante Rechteckspannung umgeformt. Das Tastverhältnis der Rechteckspannung an den Ausgängen der Diskriminatoren 16 und 17 ist proportional zu dem bereits beschriebenen Abstand der Impulse aus den Indikatorwicklungen 5. Diese Rechteckspannungen werden der Logikschaltung 18 zugeführt. Die Logikschaltung 18 ist so ausgelegt, daß bei gleichem Tastverhältnis der Rechteckspannungen der Diskriminatoren 16 und 17 entweder kein Schalter oder beide Schalter gleichsinnig angesteuert werden. Das bedeutet in beiden Fällen, daß der Kondensator 21 nicht geladen bzw. nicht umgeladen wird. Dieser Betriebsfall entspricht dem Zustand, daß durch die Meßwicklung 1 kein Strom fließt und somit die Bürde 23 nicht mit einem Strom beaufschlagt werden darf.

Als Ergebnis eines Stromflusses durch die Meßwicklung 1 ändert sich das Tastverhältnis der Rechteckspannungen am Ausgang der Diskriminatoren 16 und 17 gegensinnig zueinander. Die Logikschaltung 18 steuert dann entweder den einen Schalter 19 oder den anderen Schalter 20 oder aber auch entsprechend dem Tastverhältnis beide Schalter mit unterschiedlichen Schließzeiten. In dessen Folge wird der Kondensator 21 geladen oder entladen. Der Mittelwert der Spannung über dem Kondensator 21 ist dann stets von Null verschieden. Im Sinne eines Nullflußwandlers treibt der Verstärker 22 durch die Kompensationswicklung 4 und durch die Bürde 23 einen so großen Strom, daß sich Durchflutungsgleichgewicht im Magnetkern 2 und seinen Sonden 12 und 13 einstellt.

Sollen auch Vorgänge mit sehr hohen Frequenzen, die dem Gleichstrom überlagert sind oder allein an der Meßwicklung 1 anliegen, mit großer Genauigkeit abgebildet werden, ist es auch hier vorteilhaft, den Magnetkern 2 mit einer zusätzlichen Induktionswicklung 9 zu versehen, die direkt auf den Verstärker 22 arbeitet. Eine auf solche Weise weitergebildete Einrichtung zur Messung von Gleichströmen eignet sich neben der Messung von Gleichströmen auch zur Messung von reinen Wechselströmen. Die Sonden 12 und 13 mit ihren Vormagnetisierungswicklungen 7 sowie ihren Indikatorwicklungen 5 werden bevorzugt diametral im Magnetkern angeordnet. Findet eine größere Anzahl von Sonden Anwendung, so werden deren Vormagnetisierungswicklungen paarweise zusammengeschaltet und gegensinnig vom Wechselstromgenerator 11 gespeist.

**Patentansprüche**

1. Einrichtung zur Messung von Gleichströmen, bestehend aus einer Meßwicklung (1), die den zu messenden Gleichstrom führt, einem Magnetkreis (2) mit Isthmus (3), einer Kompensationswicklung (4), die einen den zu messenden Strom abbildenden Strom führt, einer Indikatorwicklung (5), die einen Verstärker (6, 22) ansteuert, der den Strom in der Kompensationswicklung (4) treibt, und einer Vormagnetisierungswicklung (7), die mit einem Wechselstrom beaufschlagt ist, dadurch gekennzeichnet, daß der Magnetkreis (2) im Bereich des Isthmus (3) aus einer Parallelschaltung magnetischer Leiter besteht, wovon einer (8) sowohl die Vormagnetisierungswicklung (7) als auch die Indikatorwicklung (5) trägt.

2. Einrichtung nach Anspruch 1, dadurch gekennzeichnet, daß der magnetische Leiter (8) der Parallelschaltung im Bereich des Isthmus (3), der die Wicklungen (5 und 7) trägt, aus hochpermeablem Material mit niedriger Koerzitivfeldstärke und nahezu Rechteckcharakteristik besteht.

3. Einrichtung nach Anspruch 1 oder 2, dadurch gekennzeichnet, daß alle magnetischen Leiter der Parallelschaltung im Bereich des Isthmus einschließlich ihrer magnetischen Verbindungen aus hochpermeablem Material mit niedriger Koerzitivfeldstärke und nahezu Rechteckcharakteristik bestehen.

4. Einrichtung nach einem der Ansprüche 1 bis 3, dadurch gekennzeichnet, daß der Magnetkreis (2) mehrere, im Magnetkreis vorzugsweise gleichmäßig verteilte Isthmen mit Parallelschaltungen magnetischer Leiter aufweist.

5. Einrichtung nach einem der Ansprüche 1 bis 4, dadurch gekennzeichnet, daß der magnetische Leiter (8) der Parallelschaltung, der die Indikatorwicklung (5) und die Vormagnetisierungswicklung (7) trägt, selbst einen Isthmus oder Isthmen aufweist.

6. Einrichtung nach einem der Ansprüche 1 bis 5, dadurch gekennzeichnet, daß die Indikatorwicklung (5) im Bereich des Isthmus bzw. der Isthmen des magnetischen Leiters (8) angeordnet ist.

7. Einrichtung nach einem der Ansprüche 4 bis 6, dadurch gekennzeichnet, daß eine geradzahlige Zahl von Parallelschaltungen magnetischer Leiter im Bereich der Isthmen vorgesehen ist und die Vormagnetisierungswicklungen (7) antiparallel oder antiseriell geschaltet sind, während die Indikatorwicklungen (5) in Reihe liegen.

8. Einrichtung nach einem der Ansprüche 1 bis 7, dadurch gekennzeichnet, daß die magnetischen Leiter der Parallelschaltungen aus amorphem Magnetmaterial bestehen.

9. Einrichtung nach einem der Ansprüche 1 bis 8 mit wenigstens zwei Isthmen und zwei bzw. einer geradzahligen Anzahl von Indikatorwicklungen (5), gekennzeichnet durch

– ein Differenzierglied (14, 15) für jede Indikatorwicklung (5), an dessen Eingang die Ausgangsspannung der betreffenden Indikatorwicklung (5) liegt,

– einen jedem Differenzierglied nachgeschalteten Diskriminator (16, 17), dessen Ausgang jeweils an einer Logikschaltung (18) liegt,

die so ausgebildet ist, daß an ihren Ausgängen nur dann eine Impulsfolge mit variablem Tastverhältnis vorliegt, wenn die aus Indikatorwicklungen (5) und zugehörigen Vormagnetisierungswicklungen (7) bestehenden Indikatoren entweder in positiver oder in negativer Richtung magnetisiert sind,

– zwei von Ausgängen der Logikschaltung (18) entsprechend ihrem Tastverhältnis angesteuerte Schalter (19, 20), die den Aufladestromkreis eines Kondensators (21) über eine positive bzw. negative anlegbare Spannung steuern,
und wobei dem

Verstärker (22) die am Kondensator (21) anliegende Spannung als Eingangsgröße zugeführt wird wobei der Verstärker den Strom durch eine Bürde (23) und die mit ihr in Reihe geschaltete Kompensationswicklung (4) treibt.

10. Einrichtung nach Anspruch 9, dadurch gekennzeichnet, daß bei der Anordnung von mehr als zwei Indikatorwicklungen (5) diese paarweise in Reihe geschaltet und die paarweise in Reihe geschalteten Indikatoren symmetrisch im Magnetkern (2) angeordnet sind.

11. Einrichtung nach Anspruch 9 oder 10, dadurch gekennzeichnet, daß der Magnetkern (2) noch eine zusätzliche Induktionswicklung (9) trägt, deren Ausgangsspannung eine weitere Eingangsgröße des Verstärkers (6, 22) ist, der den Strom durch die Bürde (10; 23) und die mit ihr in Reihe geschaltete Kompensationswicklung (4) treibt.

## Claims

1. Device for measuring direct currents comprising a measuring coil (1), which carries the direct current to be measured, a magnetic circuit (2) with an isthmus (3), a compensation coil (4), which carries the current reflecting the current to be measured, an indicator coil (5), which leads to an amplifier (6, 22) driving the current in the compensation coil (4), and a magnetisation coil (7), which is supplied with an alternating current, characterised in that the magnetic circuit (2) is composed of a parallel circuit of magnetic conductors in the region of the isthmus (3), wherein one of those (8) carries the magnetisation coil (7) as well as the indicator coil (5).

2. Device according to claim 1, characterised in that the magnetic conductor (8) of the parallel circuit in the region of the isthmus (3) which carries the coils (5 and 7), is made of highly permeable material having a low coercive force and almost rectangular characteristics.

3. Device according to claim 1 or 2, characterised in that all magnetic conductors of the parallel circuit in the region of the isthmus (3) inclusive of their magnetic connections are made of highly permeable material having a low coercive force and almost rectangular characteristics.

4. Device according to one of claims 1 to 3, characterised in that the magnetic circuit (2) comprises several isthmuses having parallel circuits of magnetic conductors, which are distributed preferably evenly in the magnetic circuit.

5. Device according to one of claims 1 to 4, characterised in that the magnetic conductor (8) of the parallel circuit which is carrying the indicator coil (5) and the magnetisation coil (7), also comprises an isthmus or isthmuses.

6. Device according to one of claims 1 to 5, characterised in that the indicator coil (5) is arranged in the region of the isthmus or isthmuses of the magnetic conductor (8).

7. Device according to one of claims 4 to 6, characterised in that there is provided an even number of parallel circuits of magnetic conductors in the region of the isthmuses, and that the magnetisation coils (7) are connected anti-parallel or anti-in-series while the indicator coils (5) are connected in series.

8. Device according to one of claims 1 to 7, characterised in that the magnetic conductors of the parallel circuits are made of amorphous magnetic material.

9. Device according to one of claims 1 to 8 comprising at least two isthmuses and two or an even number of indicator coils (5), characterised by
– a differential link (14, 15) for every indicator coil (5), at the input of which lies the output voltage of the corresponding indicator coil (5),
– a discriminator (16, 17) connected behind every differential link, the output of which is connected to a logic control (18) respectively,
which is developed in such a way that a pulse train with variable keying ratio exists at its outputs only when the indicators, which comprise of indicator coils (5) and accompanying magnetisation coils (7), are magnetised in either positive or negative direction,
– two switches (19, 20) controlled by outputs of the logic control (18) according to its keying ratio which in turn control the charging circuit of a capacitor (21) via a positive or negative voltage to be applied
and whereby
the voltage at the capacitor (21) is fed to the amplifier (22) as input quantity whereby the amplifier drives the current though a load (23) and the compensation coil (4) connected in series therewith.

10. Device according to claim 9, characterised in that, with the arrangement of more than two indicator coils (5), these are connected in pairs in series and that the indicators connected in pairs in series are arranged symmetrically in the magnetic core (2).

11. Device according to claim 9 or 10, characterised in that the magnetic core (2) also carries an additional induction coil (9), the output voltage thereof being a further input quantity for the amplifier (6, 22) which drives the current through the load (10, 23) and the compensation coil (4) connected in series therewith.

**Revendications**

1. Dispositif de mesure de courants continus, constitué d'un bobinage de mesure (1), dans lequel passe le courant continu à mesurer, un circuit magnétique (2) avec un isthme (3), un bobinage de compensation (4), qui laisse passer un courant représentant le courant à mesurer, un bobinage indicateur (5) qui commande un amplificateur (6, 22), qui envoie le courant dans le bobinage de compensation (4) et un bobinage de préaimantation (7), qui est alimenté en courant alternatif, caractérisé en ce que le circuit magnétique (2) dans la zone de l'isthme (3) est constitué d'un circuit parallèle de conducteur magnétique, dont l'un (8) porte aussi bien le bobinage de préaimantation (7) que le bobinage indicateur (5).

2. Dispositif selon la revendication 1, caractérisé en ce que le conducteur magnétique (8) du circuit parallèle dans la zone de l'isthme (3), qui porte les bobinages (5 et 7) est constitué d'un matériau hautement perméable avec une force de champ coercitif faible et une caractéristique presque rectangulaire.

3. Dispositif selon la revendication 1 ou 2, caractérisé en ce que tous les conducteurs magnétiques du circuit parallèle dans la zone de l'isthme réalisent leurs liaisons magnétiques exclusivement grâce à du matériau hautement perméable à faible force de champ coercitif et à caractéristique presque rectangulaire.

4. Dispositif selon l'une des revendications 1 à 3, caractérisé en ce que le circuit magnétique (2) présente plusieurs isthmes répartis régulièrement de préférence sur le circuit magnétique avec des circuits parallèles de conducteurs magnétiques.

5. Dispositif selon l'une des revendications 1 à 4, caractérisé en ce que le conducteur magnétique (8) du circuit parallèle, qui porte le bobinage indicateur (5) et le bobinage de préaimantation (7) présente lui-même un isthme ou des isthmes.

6. Dispositif selon l'une des revendications 1 à 5, caractérisé en ce que le bobinage indicateur (5) est disposé dans la zone de l'isthme ou bien des isthmes du conducteur magnétique (8).

7. Dispositif selon l'une des revendications 4 à 6, caractérisé en ce qu'est prévu un nombre pair de circuits parallèles de conducteurs magnétiques dans la zone des isthmes et que les bobinages de préaimantation (7) sont branchés de façon antiparallèle ou antisérielle, alors que les bobinages indicateurs (5) sont en série.

8. Dispositif selon l'une des revendications 1 à 7, caractérisé en ce que les conducteurs magnétiques des circuits parallèles sont constitués de matériau magnétique amorphe.

9. Dispositif selon l'une des revendications 1 à 8, avec au moins deux isthmes et deux ou un nombre pair de bobinages indicateurs (5), caractérisé en ce que
– il y a un élément différenciateur (14, 15) pour chaque bobinage indicateur (5), à l'entrée duquel est appliquée la tension de sortie du bobinage indicateur correspondant (5),
– un discriminateur est branché après chaque élément différenciateur (16, 17), dont la sortie est appliquée à un circuit logique (18),
qui est constitué de telle façon que, à leurs sorties, il n'y a qu'une succession d'impulsions à taux d'impulsion variable, quand les indicateurs constitués des bobinages indicateurs (5) et des bobinages de préaimantation correspondants (7) sont aimantés soit en sens positif, soit en sens négatif,
– deux interrupteurs (19, 20) commandés selon leur taux d'impulsion par les sorties du circuit logique (18), commandent le circuit de charge d'un condensateur (21) grâce à une tension qui peut être établie, positive ou négative,
et/ou

la tension existant aux bornes du condensateur (21) est appliquée comme donnée d'entrée à l'amplificateur, l'amplificateur fournissant le courant à une charge (23) et aux bobinages de compensation (4) qui sont en série avec elle.

10. Dispositif selon la revendication 9, caractérisé en ce que, pour la disposition de plus de deux bobinages indicateurs (5), ceux-ci sont branchés par paire en série, et les indicateurs branchés en série par paire sont répartis symétriquement sur le circuit magnétique (2).

11. Dispositif selon la revendication 9 ou 10, caractérisé en ce que le circuit magnétique (2) porte un autre bobinage inductif (9), dont la tension de sortie est une autre grandeur d'entrée de l'amplificateur (6, 22), qui envoie du courant dans la charge (10; 23) et le bobinage de compensation qui est branché en série avec elle.

11

2

3

1

7

7

8

8

5

5

3

4

9

10

6

**Fig . 1**

2a    2b    2c    2d    2e    2f    2g

**Fig. 2**

Fig. 3